## Europäisches Patentamt
## European Patent Office
## Office européen des brevets

(19)

(11) Veröffentlichungsnummer: **0 033 380**
**B1**

(12) # EUROPÄISCHE PATENTSCHRIFT

(45) Veröffentlichungstag der Patentschrift:
03.02.88

(51) Int. Cl.⁴: **H 01 L 31/10,** H 01 L 31/18

(21) Anmeldenummer: **80107799.1**

(22) Anmeldetag: **11.12.80**

(54) **Passivierter Halbleiter pn-Übergang mit hoher Spannungsfestigkeit.**

(30) Priorität: **31.01.80 DE 3003391**

(43) Veröffentlichungstag der Anmeldung:
**12.08.81 Patentblatt 81/32**

(45) Bekanntmachung des Hinweises auf die Patenterteilung:
**03.02.88 Patentblatt 88/5**

(84) Benannte Vertragsstaaten:
**CH DE FR GB LI SE**

(56) Entgegenhaltungen:
**DE-A-2 649 078**
**US-A-3 596 347**

(73) Patentinhaber: **Kemmer, Josef, Dr., Hauptstrasse 41 D, D-8041 Haimhausen (DE)**

(72) Erfinder: **Kemmer, Josef, Dr., Hauptstrasse 41 D, D-8041 Haimhausen (DE)**

(74) Vertreter: **Hansmann, Dierk, Dipl.- Ing., Jessenstrasse 4, D-2000 Hamburg 50 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen passivierten Halbleiter pn-Übergang, insbesondere für Strahlungsdetektoren, mit einem Bereich sehr hoher Dotierung, der eine Dicke in der Größenordnung von 0,1 μm aufweist, sowie ein Verfahren zu seiner Herstellung.

Für die Herstellung von optischen Detektoren und Kernstrahlungsdetektoren werden sogenannte flache Halbleiter pn-Übergänge hoher Spannungsfestigkeit benötigt. Passivierte Halbleiter pn-Übergänge für Strahlungsdetektoren ähnlicher Art sind bekannt (DE-A-26 55 685, DE-A-26 49 078). Bekannte Halbleiter pn-Übergänge sind zumeist großflächig ausgebildet und weisen in der Regel eine stark asymmetrische möglichst abrupte Dotierung auf. Die Raumladungszone, die zum Nachweis der Strahlung dient, erstreckt sich dann fast ausschließlich in den niedrig dotierten Halbleiter. Als Eintrittsfenster für die durch den Detektor zu erfassende Strahlung dient der hochdotierte Teil des pn-Überganges, der zur Vermeidung von Absorbtionsverlusten möglichst dünn ausgebildet wird, beispielsweise in der Größenordnung von 0,1 μm. Bei Strahlungen kurzer Reichweite, beispielsweise bei Korpuskularstrahlung liegt im allgemeinen eine Passivierung des Eintrittsfensters durch $SiO_2$ oder $Si_3N_4$ nicht zulässig. Eine solche Passivierung erstreckt sich lediglich über die Randzone und dient zur Reduktion von Oberflächenströmen und Umwelteinflüssen.

Grundsätzlich gilt, daß die Durchbruchspannungen solcher pn-Übergänge u.a. vom Krümmungsradius an den Randzonen der dotierten Schichten beeinflußt werden. Um jedoch einen größeren Krümmungsradius zu erhalten, der höhere Betriebsspannungen erlaubt, wählt man deshalb als Dotierungstechnik die Diffusion, bei der eine starke Dotierung unter der zu schützenden Passivierungsschicht erreicht wird. Bei voraussetzungsgemäß flach diffundierten pn-Strukturen ist der Krümmungsradius der Randzone äußerst gering, was zu hohen lokalen Feldstärken und damit zu niedrigen Durchbruchspannungen führt.

Das gleiche gilt bei der Anwendung der Dotierungstechnik mittels Ionenimplantation.

Einen zusätzlichen negativen Einfluß auf die Durchbruchspannung hat ein Anreicherungskanal zwischen der Schutzschicht und dem darunter liegenden Halbleiter (Oberflächenanreicherungskanal). Dieser Zustand ist in der Regel immer gegeben bei der Passivierung von n-Si der Orientierung (111) mit thermisch erzeugtem $SiO_2$.

Liegt dagegen ein Oberflächenverarmungskanal vor, so führt dieser zu einer Erniedrigung der Randfeldstärke, d. h. zu höheren Durchbruchspannungen.

Es ist Aufgabe der vorliegenden Erfindung, einen passivierten Halbleiterübergang zu schaffen, bei dem ein Bereich sehr hoch dotiert und sehr dünn ist, sowie ein Verfahren zu schaffen, mit dem ein Halbleiter pn-Übergang hoher Spannungsfestigkeit auf einfache und sichere Weise hergestellt werden kann.

Gelöst wird die Aufgabe gemäß der Erfindung dadurch, daß an der Randzone des pn-Überganges eine als Verarmungskanal wirkende Umdotierungzone unterhalb der Passivierungsschicht ausgebildet ist.

Ein Vorteil der Begrenzung der Kanaldotierung auf eine schmale Randzone um den pn-Übergang liegt darin, daß nur eine geringfügige Zunahme der Kapazität und des Sperrstromes des pn-Elementes erreicht wird. Darüberhinaus verhindert die Kanaldotierung Umwelteinflüsse auf die Randzone des pn-Überganges und führt deshalb zu einer höheren Stabilität des pn-Überganges.

Bei dem zur Lösung der Aufgabe vorgeschlagenen Verfahren werden in einer Passivierungsschicht, die zuvor auf einem Halbleitersubstrat des n-Typs aufgebracht worden ist, von der passivierenden Schicht freie Fenster ausgebildet, anschließend werden die Fenster umgebende Randbereiche der Schicht in ihrer Dicke keil- oder stufenförmig verringert und schließlich erfolgt nachfolgend durch die in ihrer Dicke verminderten Randbereiche hindurch eine Dotierung zur Ausbildung der als Verarmungskanal wirkenden Umdotierungzone im Halbleiter des n-Typs unterhalb der, in ihrer Dicke verminderten Randbereiche. Grundsätzlich ist somit am Rand um den pn-Übergang eine Dotierung des Kanals unabhängig von der Herstellung des pn-Überganges möglich.

Vorteilhafterweise kann jedoch die Kanaldotierung gleichzeitig mit der Herstellung des pn-Überganges erfolgen, so daß dann keine zusätzlichen Dotierschritte notwendig werden.

Vorteilhafterweise kann die keil- oder stufenförmige Verringerung der Dicke der Passivierungsschicht am Fensterrand mittels Photolithographie, Plasmaätzung, Ionenätzung oder auch Oxyd- oder Nitridpassivierungstechniken ausgeführt werden, und zwar auch gleichzeitig mit dem Öffnen der Fenster.

Die Erfindung wird nun unter Bezugnahme auf die nachfolgenden schematischen Zeichnungen anhand eines Ausführungsbeispieles beschrieben. Darin zeigen:

Fig. 1a bis 1f
in mehreren Stufen den Herstellungsvorgang eines Halbleiter pn-Überganges und

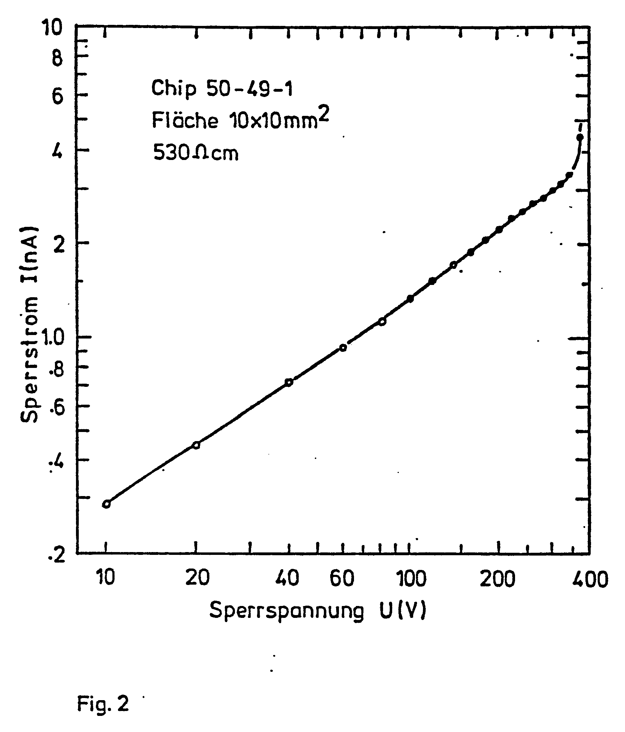

Fig. 2 eine typische Stromcharakteristik eines nach einem erfindungsgemäßen Verfahren herstgestellten Chips.

Nachfolgend wird die Herstellung eines Halbleiter-pn-Überganges mit Hilfe der Planartechnik unter Einsatz der Ionenimplantation beschrieben, wobei ein so hergestellter pn-Übergang bei Kernstrahlungsdetektoren Anwendung findet.

Grundsätzlich können auch andere technologische Verfahren zur Herstellung von pn-Strukturen in Silicium angewendet werden, beispielsweise die Dotierung mittels Diffusionstechniken.

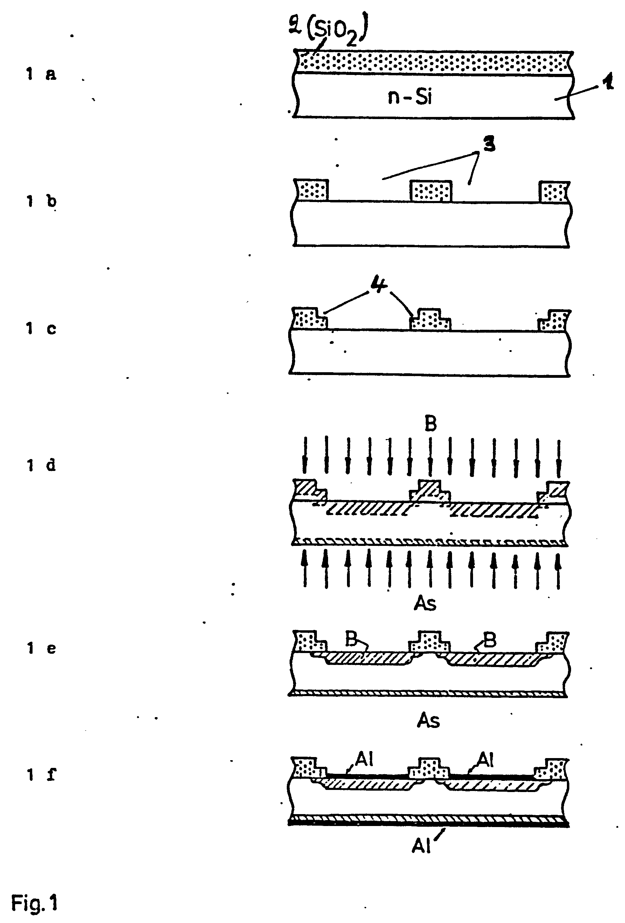

Als Ausgangsmaterial dienen n-Si-Scheiben 1 mit einem spezifischen Widerstand von 2 k $\Omega$.cm und mit einer Ladungsträgerlebensdauer von ca. 1 msec. Die Si-Scheiben sind senkrecht zur (111)-Achse geschnitten. Der Scheibendurchmesser beträgt 50.8 mm, die Dicke 300 µm. Die polierten, gereinigten Scheiben werden zunächst durch thermische Oxidation mit einer 200nm (2000 Å) dicken SiO$_2$ Schutzschicht 2 versehen (Fig. 1a). Anschließend werden im Oxid durch einen photolithographischen Schritt Fenster 3 von 10 x 10 mm$^2$ Fläche geöffnet (Fig. 1b). Zur Oberflächenpassivierung ist nun jeder Chip mit einem SiO$_2$-Rand von 1.5 mm Breite umgeben. In einem zweiten photolithographischen Schritt werden nun Stufen 4 von 100nm (1000 Å) Dicke und 100 µm Breite in den SiO$_2$-Rand geätzt (Fig. 1c). Die Vorderseite der Scheibe wird darauf durch Implantation mit Bor (B) in den Fenstern umdotiert (Fig. 1d).

Das passivierende SiO$_2$ schützt das darunter liegende Si außerhalb der Fenster vor unerwünschter Dotierung. Die Energie und Dosis der Bor Ionen ist mit 15 KeV bzw. 5 x 10$^{14}$ cm$^{-2}$ so bemessen, daß ein gewisser Anteil die Stufe durchdringt und eine gezielte Umdotierung des Kanals ermöglicht wird. Die Rückseite der Scheiben wird mit Arsen (As) von 30 KeV und einer Dosis von 5 x 10$^{15}$ c$^{-2}$ implantiert. Die Proben werden anschließend bei 600° C getempert (Fig. 1e) und mit Aluminium (Al) metallisiert (Fig. 1f). Nach dem Zerteilen der Scheiben sind die Chips fertig für die Montage.

Mit diesem Verfahren können Detektorchips hergestellt werden, die sowohl hohe Spannungsfestigkeit als auch extrem niedrige Sperrströme aufweisen. Ihre Eigenschaften als Detektoren für Alpha- oder Beta-Strahlung sind bisher unübertroffen. Fig. 2 zeigt eine typische Strom-Spannungscharakteristik eines solchen Chips. Da Durchbrüche am pn-Übergang vermieden werden, erfolgt der Stromanstieg erst durch Ladungsträgerinjetion, wenn die Raumladungszone den Rückkontakt erreicht.

Für die Herstellung der erfindungsgemäßen Strahlungsdetektoren wird die Dotierung durch Ionenimplantation bevorzugt, weil sie keinen Hochtemperaturprozeß erfordert und die Herstellung sehr dünner, hochdotierter Bereiche ermöglicht.

**Patentansprüche**

1. Passivierter Halbleiter-pn-Übergang, insbesondere für Strahlungsdetektoren, bestehend aus einem planaren hoch-dotierten Bereich von etwa 0,1 µm Dicke der einem Halbleitersubstrat entgegengesetzten Leitfähigkeitstyps gebildet ist, dadurch gekennzeichnet, daß an der Randzone des pn-Überganges eine als Verarmungskanal wirkende Umdotierungszone unterhalb der Passivierungsschicht ausgebildet ist.

Halbleiter-pn-Übergang nach Anspruch 1, dadurch gekennzeichnet, daß die Passivierungsschicht an der Randzone des pn-Überganges eine geringere zum pn-Übergang hin abnehmende Schutzwirkung gegen Dotierung aufweist.

3. Verfahren zur Herstellung eines planarem Halbleiter-pn-Überganges nach einem der Ansprüche 1 oder 2, dadurch gekennzeichnet, daß in einer Passivierungsschicht, die aus einer maskierende Schicht oder aus Kombinationen mehrerer unterschiedlicher maskierender Schichten besteht, und auf einem Halbleitersubstrat des n-Typs aufgebracht worden ist, von der Passivierungsschicht freie Fenster ausgebildet werden, daß anschließend die Fenster umgebende Randbereiche der Schicht in ihrer Dicke keil- oder stufenförmig verringert werden, und daß nachfolgend durch die in ihrer Dicke verminderten Randbereiche hindurch eine p-Dotierung zur Ausbildung der als Verarmungskanal wirkenden Umdotierungzone im Halbleitersubstrat des n-Typs unterhalb der in ihrer Dicke verminderten Randbereiche erfolgt.

4. Verfahren nach Anspruch 3, dadurch gekennzeichnet, daß gleichzeitig mit der Ausbildung der als Verarmungskanal wirkenden Umdotierungszone ein hochdotierter p-Bereich im Halbleitersubstrat unter dem von der Passivierungsschicht freien Fenster ausgebildet wird.

5. Verfahren nach einem oder beiden der Ansprüche 3 oder 4, dadurch gekennzeichnet, daß die Verringerung der Dicke der Passivierungsschicht am Fensterrand mittels Photolithographie ausgeführt wird.

6. Verfahren nach einem oder mehreren der Ansprüche 3 bis 5, dadurch gekennzeichnet, daß die Verringerung der Dicke der Passivierungsschicht am Fensterrand mittels Plasmaätzung erfolgt.

7. Verfahren nach einem oder mehreren der Ansprüche 3 bis 6, dadurch gekennzeichnet, daß die Verringerung der Dicke der Passivierungsschicht am Fensterrand mittels Ionenätzung erfolgt.

8. Verfahren nach einem oder mehreren der Ansprüche 3 bis 7, dadurch gekennzeichnet, daß als Dotierungsverfahren eine Ionenimplantation angewandt wird.

9. Verfahren nach einem oder mehreren der Ansprüche 3 bis 8, dadurch gekennzeichnet, daß als Dotierverfahren eine Diffusionsdotierung angewandt wird.

10. Verfahren nach Anspruch 9, dadurch gekennzeichnet, daß der Halbleitersubstrat aus n-Silizium ist und zur Ionenimplantation Bor-Ionen verwendet werden.

11. Verfahren nach einem oder mehreren der Ansprüche 3 bis 7, dadurch gekennzeichnet, daß die Dotierung des pn-Überganges durch Diffusion und die Dotierung der als Verarmungskanal wirkende Umdotierungszone durch Ionenimplantation durchgeführt wird.

## Claims

1. Passivated semiconductor pn junction, especially for radiation detectors, consisting of a planar, highly doped region of about 0.1 μm thickness, which is formed in a semiconductor substrate of opposite conductivity type, characterized in that, at the edge zone of the pn junction, a redoping zone acting as a depletion channel is formed underneath the passivation layer.

2. Semiconductor pn junction according to Claim 1, characterized in that the passivation layer at the edge zone of the pn junction has a lower protective effect, which decreases towards the pn junction, against doping.

3. Process for producing a planar semiconductor pn junction according to one of Claims 1 or 2, characterized in that, in a passivation layer which consists of a masking layer or of combinations of several different masking layers and which has been applied to an n-type semiconductor substrate, windows are formed which are free of passivation layer, that subsequently the thickness of the layer edge zones surrounding the windows is reduced in the form of wedges or steps, and that p-doping is then carried out through the edge zones of reduced thickness, in order to form the redoping zone, acting as a depletion channel, in the n-type semiconductor substrate underneath the edge zones of reduced thickness.

4. Process according to Claim 3, characterized in that, simultaneously with the formation of the redoping zone acting as a depletion channel, a highly doped p-region is formed in the semiconductor substrate below the window free of passivation layer.

5. Process according to one or both of Claims 3 or 4, characterized in that the thickness reduction of the passivation layer at the window edge is carried out by means of photolithography.

6. Process according to one or more of Claims 3 to 5, characterized in that the thickness reduction of the passivation layer at the window edge is carried out by means of plasma etching.

7. Process according to one or more of Claims 3 to 6, characterized in that the thickness reduction of the passivation layer at the window edge is carried out by means of ion etching.

8. Process according to one or more of Claims 3 to 7, characterized in that ion implantation is used as the doping method.

9. Process according to one or more of Claims 3 to 8, characterized in that diffusion doping is used as the doping method.

10. Process according to Claim 9, characterized in that the semiconductor substrate consists of n-silicon and boron ions are used for ion implantation.

11. Process according to one or more of Claims 3 to 7, characterized in that doping of the pn junction is effected by diffusion and doping of the redoping zone acting as depletion channel is carried out by ion implantation.

## Revendications

1. Semi-conducteur à jonction pn passivée, en particulier pour détecteurs de rayonnement, qui comporte une zone planaire fortement dopée se présentant en une épaisseur d'environ 0,1 μm formée dans un substrat de semi-conducteur de type de conductivité opposé, le semi-conducteur à jonction pn passivée étant caractérisé en ce que dans la zone marginale de la jonction pn, il est formé en dessous de la couche de passivation une zone de dopage agissant comme canal d'appauvrissement.

2. Semi-conducteur à jonction pn suivant la revendication 1, caractérisé en ce que la couche de passivation de la zone marginale de la jonction pn présente un effet de protection relativement faible contre le dopage, effet de protection qui va en diminuant en direction de la jonction pn.

3. Procédé de fabrication d'un semi-conducteur à jonction pn planaire suivant l'une ou l'autre des revendications 1 et 2, caractérisé en ce que dans une couche de passivation qui se compose d'une couche de masquage ou d'une combinaison de plusieurs couches de masquage différentes et qui a été déposée sur un substrat de semi-conducteur du type n, il est formé des fenêtres exemptes de la couche de passivation, en ce que les zones marginales de la couche qui entourent les fenêtres sont ensuite réduites d'épaisseur par formation de coins ou de degrés et en ce qu'enfin, à travers les zones marginales, dont l'épaisseur a été réduite, a lieu un p-dopage pour la formation de la zone de dopage agissant comme canal d'appauvrissement dans le substrat de semi-conducteur du type n, en dessous des zones marginales d'épaisseur réduite.

4. Procédé suivant la revendication 3, caractérisé en ce qu'en même temps qu'est formée la zone de dopage agissant comme canal d'appauvrissement, il est formé une zone p fortement dopée dans le substrat de semi-conducteur en dessous de la fenêtre exempte de la couche de passivation.

5. Procédé suivant l'une ou l'autre des revendications 3 et 4 ou suivant les deux revendications 3 et 4, caractérisé en ce que la diminution de l'épaisseur de la couche de passivation au bord des fenêtres est produite par photolithographie.

6. Procédé suivant l'une ou plusieurs des revendications 3 à 5, caractérisé en ce que la diminution de l'épaisseur de la couche de passivation au bord des fenêtres est produite par attaque de plasma.

7. Procédé suivant l'une ou plusieurs des revendications 3 à 6, caractérisé en ce que la diminution de l'épaisseur de la couche de passivation au bord des fenêtres est produite par attaque ionique.

8. Procédé suivant l'une ou plusieurs des revendications 3 à 7, caractérisé en ce que le procédé de dopage utilisé consiste en une implantation d'ions.

9. Procédé suivant l'une ou plusieurs des revendications 3 à 8, caractérisé en ce que le procédé de dopage utilisé consiste en un dopage par diffusion.

10. Procédé suivant la revendication 9, caractérisé en ce que le substrat de semi-conducteur est formé de n-silicium et en ce que pour l'implantation d'ions, il est utilisé des ions de bore.

11. Procédé suivant l'une ou plusieurs des revendications 3 à 7, caractérisé en ce que le dopage de la jonction pn est effectué par diffusion et en ce que le dopage de la zone de dopage agissant comme canal d'appauvrissement est effectué par implantation d'ions.

Fig. 1

Fig. 2